# EUROPÄISCHE PATENTSCHRIFT

(11) **EP 3 443 374 B1**
(45) Veröffentlichungstag und Bekanntmachung des Hinweises auf die Patenterteilung: **26.03.2025**
(21) Anmeldenummer: 17717323.4
(22) Anmeldetag: 10.04.2017
(51) Int. Cl.: G01R 35/00, G01R 27/28, H01R 35/00

(54) **KALIBRIERVORRICHTUNG**
CALIBRATION DEVICE
DISPOSITIF D'ÉTALONNAGE

(30) Priorität: 13.04.2016 DE 102016004527
(43) Veröffentlichungstag der Anmeldung: 20.02.2019
(73) Patentinhaber: Rosenberger Hochfrequenztechnik GmbH & Co. KG, 83413 Fridolfing (DE)
(72) Erfinder: PANICKE, Marcel, 01099 Dresden (DE); Hantschel, Markus, 01744 Dippoldiswalde (DE); MARK, Ronny, 01219 Dresden (DE)
(74) Vertreter: Warneke, Nicola
(86) Internationale Anmeldenummer: PCT/EP2017/000458
(87) Internationale Veröffentlichungsnummer: WO 2017/178107

(56) Entgegenhaltungen:
- EP-A1- 1 596 479
- EP-A1- 2 031 709
- JP-A- 2003 078 780
- JP-A- 2009 093 830
- JP-A- 2011 150 891
- JP-A- 2013 207 656
- US-A1- 2009 149 050
- US-B1- 7 416 416
- SPINNER: "OSLT compact calibration kit", 9 June 2011 (2011-06-09), XP055394694, Retrieved from the Internet <URL:http://rtelecom.net/userfiles/product_files_shared/Spinner/BN533844/533844-DS.pdf> [retrieved on 20170728]

## Beschreibung

### GEBIET DER ERFINDUNG

Die vorliegende Erfindung betrifft eine Kalibriervorrichtung sowie ein Betriebsverfahren für eine Kalibriervorrichtung.

### TECHNISCHER HINTERGRUND

Aus der WO 2006/034801 ist bekannt, dass vektorielle Netzwerkanalysatoren vor Ausführung einer Messung der Transmissions- und Reflexions- Koeffizienten eines Messobjektes kalibriert werden müssen. Hierbei werden an mehreren bekannten, voneinander verschiedenen Kalibrierstandards jeweils Koeffizientenmessungen durchgeführt, aus denen Fehlerterme berechnet werden, mit denen dann bei der eigentlichen Objektmessung Systemfehlerkorrekturen durchgeführt werden. Als Kalibrierstandards werden beispielsweise ein Leerlauf (O-pen), ein Kurzschluss (Short), ein Abschlusswiderstand (Load), eine Anpassung (Match) oder eine Durchverbindung (Thru) benutzt, die nacheinander an die Messtore angeschaltet werden. Es ist bekannt, diese Kalibrierstandards beispielsweise in einen Grundkörper anzuordnen, von dem seitlich jeweils Konnektoren abstehen. Eine solche Kalibriereinheit mit fest dimensionierten Kalibrierstellen wird zum Kalibrieren über Stecker und Kabel mit den entsprechenden Messtoren des Netzwerkanalysators verbunden.

Beispielsweise zeigt die EP 2 101 182 A2 eine Anordnung zum Kalibrieren eines Vektornetzwerkanalysators in einem Labor. Hierbei werden nacheinander verschiedene Kalibrierkomponenten an den Netzwerkanalysator angeschlossen. Diese Anordnung kann nachteilig sein, beispielsweise wenn ein Netzwerkanalysator in einem Feld oder in einem Außenbereich kalibriert werden soll, da hierfür eine erhebliche Anzahl an Einzelteilen mitzuführen ist.

Um dies zu vermeiden, sind aus dem Stand der Technik verschiedene Kompakt-Kalibrierkits, etwa der Anritsu TOSLK(F)50A-40 oder der Spinner 533898 bekannt.

Auch das Dokument "OSLT compact calibration kit" vom 09.06.2011, XP055394694, veröffentlicht von der Spinner GmbH zeigt eine kompakte Kalibrieranordnung zum Kalibrieren eines Netzwerkanalysators mit mehreren Kalibrierstellen zur direkten oder indirekten Verbindung an einen Netzwerkanalysator und mit einem Grundkörper, welcher mit den Kalibrierstellen verbunden ist.

Der bekannte Stand der Technik weist jedoch in der Regel mechanische Nachteile auf, welche sich beispielsweise nachteilig auf die Lebensdauer des Kalibrierkits auswirken, oder elektrische Nachteile, welche sich nachteilig auf die Genauigkeit der Kalibrierung auswirken.

Dies ist ein Zustand, den es zu verbessern gilt.

### ZUSAMMENFASSUNG DER ERFINDUNG

Vor diesem Hintergrund liegt der vorliegenden Erfindung die Aufgabe zugrunde, eine verbesserte Kalibrieranordnung anzugeben, welche die Lebensdauer einer Kalibrieranordnung verlängert.

Erfindungsgemäß wird diese Aufgabe durch eine Kalibrieranordnung mit den Merkmalen des Patentanspruchs 1 und/oder durch ein Verfahren mit den Merkmalen des Patentanspruches gelöst.

Demgemäß ist vorgesehen:
eine Kalibrieranordnung zum Kalibrieren eines Netzwerkanalysators mit
   - mehreren Kalibrierstellen zur direkten oder indirekten Verbindung an einen Netzwerkanalysator;
   - mit einem Grundkörper, welcher mit den Kalibrierstellen verbunden ist;
wobei die Kalibrierstelle für eine Durchverbindung gegenüber dem Grundkörper der Kalibrieranordnung verdrehbar ist.
ein Verfahren zum Betrieb einer Kalibrieranordnung mit mehreren Kalibrierstellen, welches die folgenden Schritte aufweist:
   - Verbinden einer Kalibrierstelle der Kalibrieranordnung mit einem Netzwerkanalysator für eine Anpassung, einen Kurzschluss, und/oder einen Leerlauf sowie Durchführen der entsprechenden Kalibrierung;
   - Trennen der Kalibrieranordnung und des Netzwerkanalysators;
   - Verdrehen eines Teils der Kalibrieranordnung, welcher eine Kalibrierstelle zur Herstellung einer Durchverbindung zu dem Netzwerkanalysator aufweist;
   - Herstellung einer Durchverbindung zwischen der Kalibrieranordnung und dem Netzwerkanalysator.

Die der vorliegenden Erfindung zugrunde liegende Idee besteht darin, eine Kalibrieranordnung mit mehreren Kalibrierstellen bereitzustellen, wobei die Kalibrierstelle für eine Durchverbindung gegenüber einem Grundkörper der Kalibrieranordnung verdrehbar ist.

Es versteht sich, dass die Durchverbindungskalibrierstelle einer Kalibrieranordnung ein Durchverbindungsanschlusspaar, nachfolgend mit Durchverbinder bezeichnet, aufzuweisen hat. Die vorliegende Erfindung ermöglicht eine kürzere Auslegung des Durchverbinders, da die Abmessungen weiterer Anschlüsse bzw. Kalibrierstellen der Kalibrieranordnung bezüglich der mechanischen Konstruktion des Durchverbinders nicht länger berücksichtigt werden müssen. Eine kürzere Auslegung ist hinsichtlich der elektrischen Eigenschaften der Kalibrieranordnung bzw. der Güte der Kalibrierung vorteilhaft. Auf diese Weise kann beispielsweise die Anzahl von Stützscheiben, welche den Innenleiter im Außenleiter halten, reduziert werden. Stützscheiben sind beispielsweise ursächlich für Reflexionen von elektrischen Signalen,

Die Verdrehbarkeit des Durchverbinders gegenüber dem Grundkörper der Kalibrieranordnung verlängert darüber hinaus die Lebensdauer einer Kalibrieranordnung gegenüber einer bekannten Kalibrieranordnung, dessen Durchverbinder zwar gegenüber dem Grundkörper um 90° versetzt ist, jedoch nicht verdrehbar ist.

Vorteilhafte Ausgestaltungen und Weiterbildungen ergeben sich aus den weiteren Unteransprüchen sowie aus der Beschreibung unter Bezugnahme auf die Figuren der Zeichnung.

Gemäß einer bevorzugten Ausführungsform weist der Grundkörper einen ersten Grundkörperteil und einen zweiten Grundkörperteil auf, wobei der zweite Grundkörperteil gegenüber dem ersten Grundkörperteil verdrehbar ist. Die Kopplung des Durchverbinders mit dem zweiten Grundkörperteil wirkt sich vorteilhaft auf die Lebensdauer der Kalibrieranordnung aus.

Alternativ ist es denkbar, den Durchverbinder vom Grundkörper strukturell zu trennen und lediglich den Durchverbinder verdrehbar auszulegen.

Gemäß einer weiteren bevorzugten Ausführungsform ist der erste Grundkörperteil mit dem zweiten Grundkörperteil über wenigstens ein Verbindungselement verbunden.

Alternativ ist es auch denkbar, dass der erste Grundkörperteil direkt mit dem zweiten Grundkörperteil verschraubt ist, beispielsweise indem beide Grundkörperteile korrespondierende Gewinde aufweisen.

Gemäß einer weiteren bevorzugten Ausführungsform ist das wenigstens eine Verbindungselement als Schraube, Stift, Magnet oder dergleichen ausgebildet. Auf diese Weise sind die beiden Grundkörperteile dauerhaft miteinander verbunden, was sich vorteilhaft auf die Handhabung der erfindungsgemäßen Kalibrieranordnung auswirkt.

Gemäß einer weiteren bevorzugten Ausführungsform ist die aufzubringende Kraft zum Verdrehen des Grundkörperteils über das Verbindungselement einstellbar. Beispielsweise kann die Kraft zum Verdrehen durch das Wählen einer Magnetstärke eines Verbindungselements, welches als Magnet ausgebildet ist, festgelegt werden. Alternativ ist es möglich die Kraft zum Verdrehen durch das Anziehen des Verbindungselements, welches als Schraube ausgebildet ist, festzulegen. Sofern das Verbindungselement als Stift ausgebildet ist, lässt sich die Kraft zum Verdrehen durch die Länge bzw. Dicke, über die aufzubringende Reibungskraft des Stiftes festlegen.

Auf diese Weise kann die Kraft zum Verdrehen anwendungsspezifisch während der Montage der Kalibrieranordnung festgelegt werden.

Gemäß einer weiteren bevorzugten Ausführungsform ist in dem ersten Grundkörper eine Feder zur Schraubverbindung angeordnet. Hierdurch kann ein Toleranzausgleich bereitgestellt bzw. die Haltekraft der kraftschlüssigen Verbindung direkt variiert werden. Des Weiteren verringert die Feder Verschleißerscheinungen an der erfindungsgemäßen Kalibrieranordnung durch das Verdrehen.

Gemäß einer weiteren bevorzugten Ausführungsform ist in dem Grundkörper wenigstens eine Scheibe, insbesondere eine Kunststoffscheibe, ausgebildet. Es ist vorteilhaft, die Scheibe überall dort anzuordnen, wo verschiedene Bauteile in Kontakt stehen. Die Scheibe verringert Verschleißerscheinungen durch Abrieb der beiden Reibpartner.

Insbesondere ist es vorteilhaft, die Scheibe zwischen der Feder und dem Verbindungselement und/oder zwischen der Feder und dem ersten Grundkörper und/oder zwischen dem ersten und dem zweiten Grundkörper anzuordnen, Zwischen den genannten Komponenten besteht ein erhöhtes Abriebpotential.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
- Fig. 1: zeigt eine schematische Perspektivansicht einer erfindungsgemäßen Kalibrieranordnung;
- Fig. 2: zeigt eine schematische Vorderansicht einer erfindungsgemäßen Kalibrieranordnung in einem ersten Zustand;
- Fig. 3: zeigt eine schematische Vorderansicht einer erfindungsgemäßen Kalibrieranordnung in einem zweiten Zustand;
- Fig. 4: zeigt eine schematische Schnittsicht einer erfindungsgemäßen Kalibrieranordnung gemäß einer ersten Ausführungsform;
- Fig. 5: zeigt eine schematische Perspektivansicht eines ersten Grundkörperteils einer erfindungsgemäßen Kalibrieranordnung;
- Fig. 6: zeigt eine schematische Perspektivansicht eines zweiten Grundkörperteils einer erfindungsgemäßen Kalibrieranordnung;

Die beiliegenden Figuren der Zeichnung sollen ein weiteres Verständnis der Ausführungsformen der Erfindung vermitteln.

Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

### BESCHREIBUNG VON AUSFÜHRUNGSBEISPIELEN

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

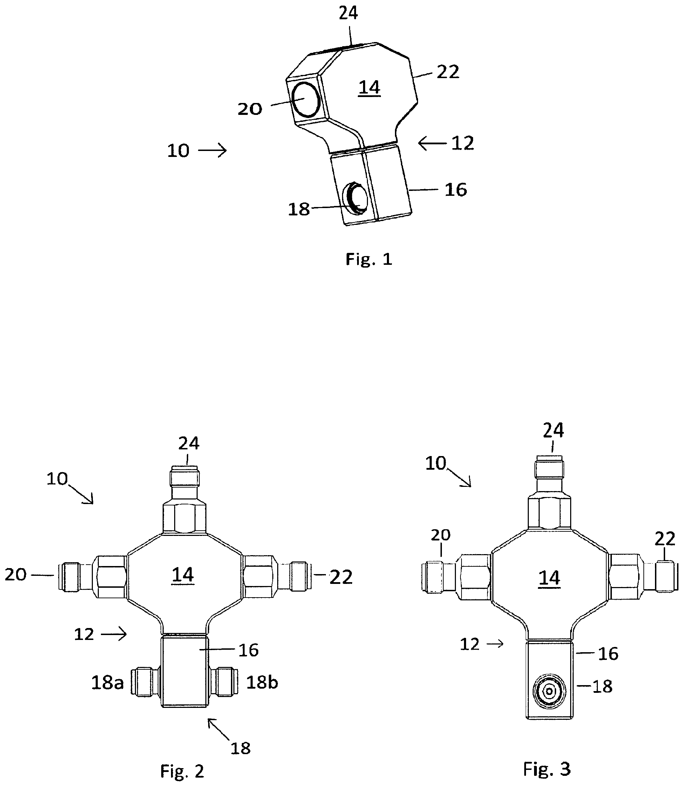

Figur 1 zeigt eine erfindungsgemäße Kalibrieranordnung 10 gemäß einer ersten Ausführungsform. Die Kalibrieranordnung 10 umfasst einen Grundkörper, welcher als in Figur 1 als vormontierte Baugruppe ausgebildet ist. Der Grundkörper 14 umfasst einen ersten Grundkörperteil 14 und einen zweiten Grundkörperteil 16. Der erste Grundkörperteil 14 weist mehrere Kalibrierstandards 20 (Short), 22 (Load/Match), 24 (O-pen) auf. Der zweite Grundkörperteil 16 weist eine Aufnahme für einen Kalibrierstandard 18 für eine Durchverbindung auf.

Der erste und der zweite Grundkörperteil 14, 16 sind über eine Schraube (in Figur 1 nicht dargestellt) verbunden. Die beiden Grundkörperteile 14, 16 sind gegenüber einander verdrehbar.

Die Montage der Kalibrieranordnung 10 in Figur 1 ist noch nicht abgeschlossen. Die Figuren 2 bzw. 3 zeigen die Kalibrieranordnung 10 gemäß Figur 1 in einem endmontierten Zustand. Figuren 2 und 3 zeigen eine Kalibrieranordnung 10 mit Anschlüssen bzw. Kalibrierstellen.

In Figur 2 ist ersichtlich, dass der Kalibrierstandard 18 für eine Durchverbindung ein Anschlusspaar mit den Anschlüssen 18a und 18b aufweist. Die Kalibrieranordnung 10 ist in Figur 2 in einem ersten Zustand dargestellt. Die Durchverbindung der Kalibrieranordnung 10 ist in dem Zustand gemäß Figur 2 möglicherweise nicht an einen Netzwerkanalysator anschließbar, da die Standards 20, 22 möglicherweise zu weit hervor stehen und somit einen Anschluss der Kalibrierstellen 18a, 18b verhindern könnten. Der Zustand gemäß Figur 2 kann somit auch als Lagerzustand bezeichnet werden. Insbesondere weist die Kalibrieranordnung 10 in Figur 2 eine flache Auflagefläche auf und ist somit besser vor dem Verkratzen oder Beschädigung des Interface der Kalibrieranschlüsse geschützt.

Figur 3 zeigt die Kalibrieranordnung 10 gemäß Figur 2 in einem zweiten Zustand, In Figur 3 ist der zweite Grundkörperteil 16 gegenüber dem ersten Grundkörperteil 14 verdreht. In dem Zustand gemäß Figur 3 lässt sich ein Netzwerkanalysator (nicht dargestellt) besonders einfach an den Standard 18 für eine Durchverbindung anschließen.

Im Gegensatz zu Figur 2 ist der Zustand gemäß Figur 3 für die Lagerung der Kalibrieranordnung 10 nur bedingt geeignet, da die Kalibrieranordnung aufgrund ihrer unebenen Beschaffenheit in dem zweiten Zustand, besonders an ihren Standards 18, 20, 22, 24 leicht verkratzt oder anderen Beschädigungen ausgesetzt sein könnte.

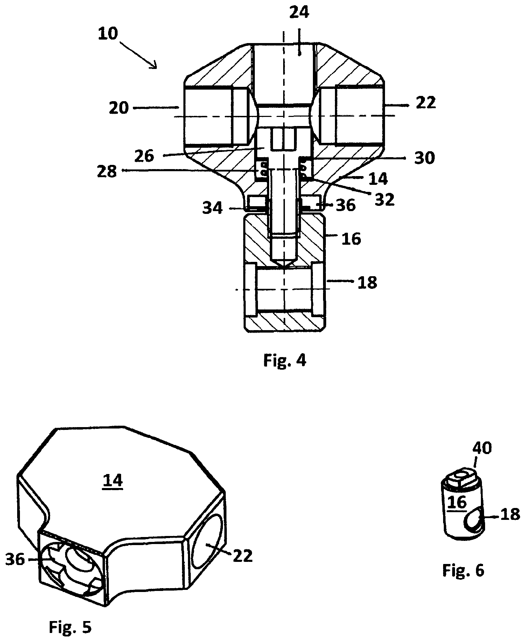

Figur 4 zeigt eine Schnittsicht einer erfindungsgemäßen Kalibrieranordnung 10 gemäß einer der Figuren 1-3. Die Kalibrieranordnung 10 weist in Figur 4 eine Schraube 26 auf, welche den ersten Grundkörperteil 14 mit dem zweiten Grundkörperteil 16 verbindet. Die Schraube 26 ist in jeweils einer Bohrung in den beiden Grundkörperteilen 14, 16 angeordnet. Der erste Grundkörperteil 14 kann gegenüber dem zweiten Grundkörperteil 16 verdreht werden, indem die Schraube 26 "mitdreht".

Zwischen einem Anschlag, welchen der Grundkörperteil durch den Boden eines Sackloches des Grundkörpers 14 bildet, und dem Kopf der Schraube 26 ist eine Feder 28 angeordnet. Die Feder 28 gewährleistet einen Toleranzausgleich und verringert Verschleißerscheinungen, welche durch das Verdrehen entstehen. Des Weiteren gewährleistet die Feder 28 eine gewisse aufzubringende Kraft, sofern die Schraube nach unten, d.h. in Richtung des zweiten Grundkörpers 16, eingeschraubt wird.

Um weiteren Verschleißerscheinungen vorzubeugen, weist die Kalibrieranordnung 10 zwischen der Feder 28 und dem Kopf der Schraube 26 eine Kunststoffscheibe 30 auf, welche verhindert, dass die Schraube auf der Feder 28 reibt. Dementsprechend ist auch zwischen der Feder 28 und dem ersten Grundkörperteil 14 eine weitere Kunststoffscheibe 32 angeordnet.

Der erste Grundkörperteil 14 weist an seiner zu dem zweiten Grundkörperteil 16 gerichteten Seite eine näherungsweise kleeblattförmige Ausnehmung 36, welche als Ausfräsung ausgebildet ist, auf. Der zweite Grundkörperteil 16 weist an seiner zu dem ersten Grundkörperteil 14 gerichteten Seite eine zu der kleeblattförmigen Ausnehmung 36 korrespondierenden Stufe 40 auf. Die Ausnehmung 36 und die Stufe 40 sind derart ausgebildet, dass die Stufe 40 in zwei verschiedenen, rechtwinklig zueinander liegenden Positionen mit der Ausnehmung 36 verrasten kann. Dementsprechend bildet die Ausnehmung 36 einen Anschlag bzw. einen Rastmechanismus für die Stufe 40.

Um die Grundkörperteile 14, 16 gegeneinander zu verdrehen, zieht ein Benutzer an dem zweiten Grundkörperteil 16, so dass die Feder 28 zusammengedrückt wird und die Stufe 40 aus der Ausnehmung 36 herausgehoben wird.

Es versteht sich, dass es auch möglich ist, die Schraube 26 und die Feder 28 in der Kalibrieranordnung 10 spiegelbildlich anzuordnen, so dass die Feder 28 sowie der Kopf der Schraube 26 in dem zweiten Grundkörperteil 16 angeordnet sind.

Figur 5 zeigt den ersten Grundkörperteil 14 der Kalibrieranordnung 10 gemäß einer der Figuren 1-4. Figur 5 zeigt insbesondere die kleeblattförmige Ausnehmung 36.

Figur 6 zeigt den zweiten Grundkörperteil 16 in runder Bauform der Kalibrieranordnung 10 gemäß einer der Figuren 1-4. Figur 6 zeigt insbesondere die Stufe 40, welche mit der Ausnehmung 36 in verschiedenen zueinander rechtwinkligen Positionen Verrasten kann.

Besonders vorteilhaft an einer beispielhaften Ausführungsform einer erfindungsgemäßen Kalibrieranordnung 10 gemäß der Figuren 1-4 ist, dass der erste Grundkörperteil 14 und der zweite Grundkörperteil 16 gegeneinander verdrehbar ist, ohne dass der zweiten Grundkörperteil 16 aus der Aufnahme 36 herzausgezogen werden muss. Hierzu ist die Aufnahme 36 derart ausgebildet, dass die Stufe 40 an dem zweiten Grundkörperteil 16 einen Anschlag in einem 90°-Winkel zur Ausgangsposition aufweist. Die Schraube 26 wird dazu soweit fest gezogen, das die Federkraft der Feder 28 genügend Gegenhalt bietet, um ein Abheben des zweiten Grundkörperteils 16 aus dem ersten Grundkörperteil 14 zu verhindern. Dies vereinfacht die Handhabung auf besonders intuitive Weise.

### Bezugszeichenliste

- 10: Kalibrieranordnung
- 12: Grundkörper
- 14: erster Grundkörperteil
- 16: zweiter Grundkörperteil
- 18: Durchverbinder-Standard
- 18a: Durchverbinderanschluss
- 18b: Durchverbinderanschluss
- 20: Short- Standard
- 22: Open- Standard
- 24: Load- Standard
- 26: Schraube
- 28: Feder
- 30: Kunststoffscheibe
- 32: Kunststoffscheibe
- 34: Kunststoffscheibe
- 36: Aufnahme
- 40: Stufe

## Patentansprüche

1. Kalibrieranordnung (10; 50) zum Kalibrieren eines Netzwerkanalysators mit
- mehreren Kalibrierstellen (18, 20, 22, 24) zur direkten oder indirekten Verbindung an einen Netzwerkanalysator, wobei eine der Kalibrierstellen (18, 20, 22, 24) eine Kalibrierstelle für eine Durchverbindung (18) ist;
- mit einem Grundkörper (10), welcher die Kalibrierstellen (18, 20, 22, 24) aufweist;
**dadurch gekennzeichnet, dass** die Kalibrierstelle für eine Durchverbindung gegenüber dem Grundkörper der Kalibrieranordnung verdrehbar ist.

2. Kalibrieranordnung (10; 50) nach Anspruch 1, wobei der Grundkörper (12) einen ersten Grundkörperteil (14) und einen zweiten Grundkörperteil (16) aufweist, wobei der zweite Grundkörperteil gegenüber dem ersten Grundkörperteil verdrehbar ist.

3. Kalibrieranordnung (10; 50) nach Anspruch 2, wobei der erste Grundkörperteil mit dem zweiten Grundkörperteil über wenigstens ein Verbindungselement (26) verbunden ist.

4. Kalibrieranordnung (10; 50) nach Anspruch 3, wobei das wenigstens eine Verbindungselement als Schraube, Mitnehmerstift, Magnet oder dergleichen ausgebildet ist.

5. Kalibrieranordnung (10; 50) nach Anspruch 3 oder 4, wobei die aufzubringende Kraft zum Verdrehen des ersten und/oder zweiten Grundkörperteils über das Verbindungselement einstellbar ist.

6. Kalibrieranordnung (10; 50) nach Anspruch einem der vorstehenden Ansprüche, wobei in dem ersten Grundkörperteil und/oder in dem zweiten Grundkörperteil eine Feder (28) angeordnet ist.

7. Kalibrieranordnung (10; 50) nach einem der vorstehenden Ansprüche, wobei in dem Grundkörper (12) wenigstens eine Scheibe (30; 32; 34), insbesondere eine Kunststoffscheibe, ausgebildet ist.

8. Kalibrieranordnung (10; 50) nach Anspruch 7, wobei die Scheibe zwischen der Feder (28) und dem Verbindungselement und/oder zwischen der Feder (28) und dem Grundkörperteil, welcher die Feder (28) aufweist, und/oder zwischen dem ersten und dem zweiten Grundkörperteil angeordnet ist.

9. Verfahren zum Betrieb einer Kalibrieranordnung (10; 50) mit mehreren Kalibrierstellen(18, 20, 22, 24), welches die folgenden Schritte aufweist:
- Verbinden einer Kalibrierstelle der Kalibrieranordnung (10; 50) mit einem Netzwerkanalysator für eine Anpassung, einen Kurzschluss, und/oder einen Leerlauf sowie Durchführen der entsprechenden Kalibrierung;
- Trennen der Kalibrieranordnung (10; 50) und des Netzwerkanalysators;
- Verdrehen eines Teils der Kalibrieranordnung gegenüber dem Grundkörper der Kalibrieranordnung, wobei dieser Teil eine Kalibrierstelle zur Herstellung einer Durchverbindung zu dem Netzwerkanalysator aufweist;
- Herstellung einer Durchverbindung zwischen der Kalibrieranordnung (10; 50) und dem Netzwerkanalysator.

## Claims

1. Calibration arrangement (10; 50) for calibrating a network analyser with
- multiple calibration points (18, 20, 22, 24) for direct or indirect connection to a network analyser, wherein one of the calibration points (18, 20, 22, 24) is a calibration point for a through connection (18);
- with a base body (10) which has the calibration points (18, 20, 22, 24);
**characterized in that** the calibration point for a through-connection is rotatable relative to the base body of the calibration arrangement.

2. Calibration arrangement (10; 50) according to claim 1, wherein the base body (12) has a first base body part (14) and a second base body part (16), wherein the second base body part is rotatable relative to the first base body part.

3. Calibration arrangement (10; 50) according to claim 2, wherein the first base body part is connected to the second base body part via at least one connecting element (26).

4. Calibration arrangement (10; 50) according to claim 3, wherein the at least one connecting element is configured as a screw, driver pin, magnet or the like.

5. Calibration arrangement (10; 50) according to claim 3 or 4, wherein the force to be applied for rotating the first and/or second base body part is adjustable via the connecting element.

6. Calibration arrangement (10; 50) according to any one of the preceding claims, wherein a spring (28) is arranged in the first base body part and/or in the second base body part.

7. Calibration arrangement (10; 50) according to any one of the preceding claims, wherein at least one disk (30; 32; 34), in particular a plastic disk, is formed in the base body (12).

8. Calibration arrangement (10; 50) according to claim 7, wherein the disc is arranged between the spring (28) and the connecting element and/or between the spring (28) and the base body part which has the spring (28), and/or between the first and the second base body part.

9. Method for operating a calibration arrangement (10; 50) with multiple calibration points (18, 20, 22, 24), which has the following steps:
- connecting a calibration point of the calibration arrangement (10; 50) to a network analyser for a matching, a short circuit, and/or an open circuit and performing the corresponding calibration;
- separating the calibration arrangement (10; 50) and the network analyser;
- rotating a part of the calibration arrangement relative to the base body of the calibration arrangement, wherein said part has a calibration point for establishing a through-connection to the network analyser;
- establishing a through-connection between the calibration arrangement (10; 50) and the network analyser.

## Revendications

1. Ensemble d'étalonnage (10 ; 50) pour l'étalonnage d'un analyseur de réseau avec
- plusieurs points d'étalonnage (18, 20, 22, 24) pour la liaison directe ou indirecte au niveau d'un analyseur de réseau, dans lequel un des points d'étalonnage (18, 20, 22, 24) est un point d'étalonnage pour une connexion transversale (18) ;
- avec un corps de base (10) qui présente les points d'étalonnage (18, 20, 22, 24) ;
**caractérisé en ce que** le point d'étalonnage pour une connexion transversale peut être tourné par rapport au corps de base de l'ensemble d'étalonnage.

2. Ensemble d'étalonnage (10 ; 50) selon la revendication 1, dans lequel le corps de base (12) présente une première partie de corps de base (14) et une seconde partie de corps de base (16), dans lequel la seconde partie de corps de base peut être tournée par rapport à la première partie de corps de base.

3. Ensemble d'étalonnage (10 ; 50) selon la revendication 2, dans lequel la première partie de corps de base est reliée à la seconde partie de corps de base par le biais d'au moins un élément de liaison (26).

4. Ensemble d'étalonnage (10 ; 50) selon la revendication 3, dans lequel le au moins un élément de liaison est réalisé comme vis, tige d'entraînement, aimant ou similaire.

5. Ensemble d'étalonnage (10 ; 50) selon la revendication 3 ou 4, dans lequel la force à appliquer est réglable pour la rotation de la première et/ou seconde partie de corps de base par le biais de l'élément de liaison.

6. Ensemble d'étalonnage (10 ; 50) selon la revendication selon l'une quelconque des revendications précédentes, dans lequel un ressort (28) est agencé dans la première partie de corps de base et/ou dans la seconde partie de corps de base.

7. Ensemble d'étalonnage (10 ; 50) selon l'une quelconque des revendications précédentes, dans lequel au moins un disque (30 ; 32 ; 34), en particulier un disque en matière plastique, est formé dans le corps de base (12).

8. Ensemble d'étalonnage (10 ; 50) selon la revendication 7, dans lequel le disque est agencé entre le ressort (28) et l'élément de liaison et/ou entre le ressort (28) et la partie de corps de base qui présente le ressort (28) et/ou entre la première et la seconde partie de corps de base.

9. Procédé de fonctionnement d'un ensemble d'étalonnage (10 ; 50) avec plusieurs points d'étalonnage (18, 20, 22, 24) qui présente les étapes suivantes :
- la liaison d'un point d'étalonnage de l'ensemble d'étalonnage (10 ; 50) avec un analyseur de réseau pour une adaptation, un court-circuit et/ou une marche à vide ainsi que l'exécution de l'étalonnage correspondant ;
- la séparation de l'ensemble d'étalonnage (10 ; 50) et de l'analyseur de réseau ;
- la rotation d'une partie de l'ensemble d'étalonnage par rapport au corps de base de l'ensemble d'étalonnage, dans lequel cette partie présente un point d'étalonnage pour l'établissement d'une connexion transversale avec l'analyseur de réseau ;
- l'établissement d'une connexion transversale entre l'ensemble d'étalonnage (10 ; 50) et l'analyseur de réseau.
